# EUROPÄISCHE PATENTSCHRIFT

(11) **EP 0 659 901 B1**
(45) Veröffentlichungstag und Bekanntmachung des Hinweises auf die Patenterteilung: **15.04.1998**
(21) Anmeldenummer: 94112342.4
(22) Anmeldetag: 08.08.1994
(51) Int. Cl.: C23C 14/34, G11B 5/64, C22C 19/00, C22F 1/00

(54) **Target für Magnetron-Kathodenzerstäubungsanlage aus einer Kobalt-Basislegierung**
Cobalt based alloy target for magnetron sputtering apparatus
Cible en alliage à base de cobalt pour appareil de pulvérisation cathodique magnétron

(30) Priorität: 24.03.1994 DE 4410114; 20.12.1993 DE 4343440
(43) Veröffentlichungstag der Anmeldung: 28.06.1995
(73) Patentinhaber: LEYBOLD MATERIALS GmbH, D-63450 Hanau (DE)
(72) Erfinder: Schlott, Martin, Dr., D-63454 Hanau (DE); Weigert, Martin, Dr., D-63457 Hanau (DE); Gehman, Bruce, Dr., Morgan Hill, CA 95037 (US); Teng, Kwei, Saratoga, CA 95037 (US)

(56) Entgegenhaltungen:
- EP-A- 0 252 478
- EP-A- 0 346 599
- EP-A- 0 535 314
- US-A- 5 004 652
- JOURNAL OF APPLIED PHYSICS, Bd.73, Nr.10, 15. Mai 1993, US Seiten 5557 - 5559, XP381191 Y. DENG ET AL 'SUBSTRATE BIAS EFFECTS ON COMPOSITION AND COERCIVITY OF COCRTA/CR THIN FILMS ON CANASITE AND GLASS'

## Beschreibung

Die Erfindung betrifft ein Target für Magnetron-Kathodenzerstäubungsanlagen aus einer Kobalt-Basislegierung Co_{1-x-y} MₓR_{y}, wobei M für mindestens eines der Elemente Cr, Pt, Ni, Pd oder ähnliche Elemente der Übergangsmetalle steht und 0 < x < 0,3 ist, R für mindestens eines der Elemente Ta, Mo, W, B, Hf, Nb, V oder ähnliche zur Bildung intermetallischer Phasen neigende Metalle steht und 0,015 < y < 0,20 ist, bestehend aus einem Gefüge aus überwiegend hexagonalen Kobalt-Mischkristallen und mit R gebildeten intermetallischen Phasen.

Beim Magnetron-Kathodenzerstäuben werden zur Optimierung des Zerstäubungsprozesses Permanentmagnete hinter dem Target (Kathode) so angeordnet, daß sich vor dem Target, im Entladungsraum, ein Magnetfeld ausbildet, durch das das Entladungsplasma lokalisiert wird. Der Bereich der Targetoberfläche, über dem das Plasma lokalisiert ist, wird bevorzugt zerstäubt, wodurch sich dort ein Erosionsgraben bildet.

Bei ferromagnetischen Targets treten dabei hauptsächlich zwei Probleme auf:
- Erstens wird der magnetische Fluß der Permanentmagnete im Target gebündelt, so daß ein geringer Fluß in den Entladungsraum dringen kann. Dieses Problem erfordert daher die Verwendung sehr dünner ferromagnetischer Targets.
- Zweitens bewirkt die lokale Querschnittsabnahme des Targets während der Kathodenzerstäubung (Erosionsgraben) bei ferromagnetischen Targets einen zunehmenden Magnetfluß direkt über dem Erosionsgraben. Dadurch tritt lokal eine höhere Ionisierungswahrscheinlichkeit des Zerstäubungsgases und lokal eine höhere Zerstäubungsrate auf mit der Folge, daß der Erosionsgraben sehr eng wird, verbunden mit einer nur geringen Materialausbeute des Targets.

Verbesserte Magnetfeldgeometrien und ein höherer Magnetfelddurchgriff können durch aufwendige Targetkonstruktionen erreicht werden. Durch Schlitze im Target, senkrecht zur Richtung des Magnetfeldes, kann der magnetische Widerstand im Target erhöht werden und ein größeres Feld im Entladunsraum erreicht werden (K. Nakamura et al. IEEE Transactions on Magnetics, Bd. MAG-18, 1982, S. 1080-1082).

Kukla et al. (IEEE Transactions on Magnetics, Bd. MAG-23, 1987, S. 137-139) beschreiben eine Kathode für ferromagnetische Materialien, die aus mehreren Einzeltargets besteht, die in zwei Ebenen übereinander angeordnet sind, um ein höheres Magnetron-Magnetfeld zu erreichen. Diese Konstruktionen sind jedoch teuer und erschweren die Magnetron-Kathodenzerstäubung.

In der DE 38 19 905 ist ein Target zum Einsatz in Magnetron-Kathodenzerstäubungsanlagen beschrieben, bei dem der magnetische Felddurchgriff durch das Einstellen einer hexagonalen (0001)-Fasertextur senkrecht zur Targetfläche erreicht werden kann und bei dem man mit einer größeren Ausgangsdicke einen besseren Ausnutzungsgrad des Targets erzielt. Nach der DE 38 19 906 wird diese (0001)-Fasertextur durch eine Kaltformung bei Temperaturen unter 400°C erreicht. Es zeigte sich jedoch, daß diese Kaltumformung nur schwer bzw. gar nicht durchführbar ist, wenn die Targets auf Grund der Legierungszusammensetzung nennenswerte Anteile an intermetallischen Phasen enthalten.

In der EP 252 478 B1 schließlich ist ein Sputtertarget aus einer Kobalt-Basislegierung beschreiben, das bei Temperaturen knapp unterhalb des Schmelzpunktes nur eine einzige kubische Phase aufweist. Durch geeignete Walzumformungen bei Temperaturen unterhalb des martensitischen Umwandlungspunktes wird dann ein Target erhalten, dessen Röntgenbeugungsdiagramm deutlich mehr hexagonale Phasenanteile aufweist, als das des direkt nach dem Gießen erhaltenen Materials.

Es zeigt sich, daß die beschriebenen Kaltumformungen wiederum nur schwer bzw. gar nicht durchführbar sind, wenn die Kobalt-Basislegierungen nennenswerte Anteile an intermetallischen Phasen enthalten. In allen Fällen traten schon bei geringen Dickenabnahmen starke Risse in den Walzenplatten auf.

Es ist daher die Aufgabe der vorliegenden Erfindung, ein Target für Magnetron-Kahodenzerstäubungsanlagen aus Kobalt-Basislegierungen zu entwickeln, die weitere Elemente in Konzentrationen enthalten, so daß mit mindestens einem der Elemente intermetallische Phasen gebildet werden und auf Grund des Phasendiagramms und der Erstarrungskinetik im Gleichgewichtszustand bei der Betriebstemperatur des Targets intermetallische Phasen feststellbar sind. Es soll dabei erreicht werden, aß das Target einen hohen Magnetfelddurchgriff aufweist, ohne daß es einer der oben beschriebenen Kaltverformungen unterworfen werden muß. Auf diese Weise sollen auch für die Klasse von Kobalt-Basislegierungen, die intermetallische Phasen enthalten, höhere Targetausbeutungen erreicht werden und größere Targetdicken einsetzbar sein.

Diese Aufgabe wird erfindungsgemäß dadurch gelöst, daß das Targetmaterial mindestens eines der beiden folgenden Merkmale aufweist:
a) Es liegt eine Matrix aus primären Kobalt-mischkristallen vor, deren Korngrenzen, Unterkorngrenzen oder Zwillingskorngrenzen oder Gleitbänder mit den die intermetallischen Phasen bildenden Elementen dekoriert sind. In die Matrix eingebettet sind mehr oder weniger ausgeprägte eutektishe Zonen, bestehend aus den Kobaltmischkristallen sowie intermetallischen Phasen.
b) Das Röntgenbeugungsdiagramm weist Röntgenreflexe einer intermetallischen Phase auf, die im Gußzustand nicht anzutreffen ist und die durch eine Festkörperreaktion unterhalb der Solidustemperatur der eingesetzten Legierung gebildet wird.

Dieses spezielle Gefüge wird dadurch erreicht, daß man das Targetmaterial nach dem Geißen und einer eventuellen Heißwalzumformung bei Temperaturen von max. 300°C unterhalb der Temperatur für die fest-fest Umwandlungsreaktion glüht. Diese Temperatur ist für jede Legierung neu mit einigen Handversuchen zu ermitteln. Üblicherweise liegt sie für die betrachteten Kobalt-Basislegierungen im Bereich von 700°C bis 1100°C. Glühungen weit unterhalb der Umwandlungstemperatur führen wegen der dann sehr geringen Diffusionsgeschwindigkeit zu sehr langsamen Umwandlungsreaktionen und entsprechend langen und unwirtschaftlichen Glühzeiten.

Die Kobalt-Basislegierung enthält neben Elementen wie Ni, Pt, PD, Cr auch Elemente wie Ta, B, Mo, W, Hf, V, Nb, die mit mindestens einem der vorgenannten Elemente intermetallische Phasen bilden, wobei der Gehalt an intermetallischen Phasen bildenden Elementen so groß sein muß, daß sie im Gleichgewichtszustand bei der Betriebstemperatur des Targets nicht mehr vollständig im Kobaltmischkristall gelöst vorliegen.

Eine bevorzugte Kobalt-Basislegierung besteht aus den Komponenten Kobalt (Co), Chrom (Cr) und Tantal (Ta), wobei der Gehalt an Ta 2,5 bis 15 at%, der Gehalt an Cr 0 bis 30 at% beträgt und der jeweilige Rest aus Co gebildet ist.

Eine alternative Kobalt-Basislegierung ist aus den Elementen Kobalt (Co), Platin (Pt), Chrom (Co) und Tantal (Ta) gebildet, wobei der Gehalt an Platin 0 bis 20 at%, der Gehalt an Cr 0 bis 25 at%, der Gehalt an Ta 1,5 bis 15 at% beträgt und der jeweilige Rest aus Co gebildet ist.

Überraschenderweise hat sich gezeigt, daß Targets, die neben den Co-Mischkristallen auch intermetallische Phasen aufweisen, nach einer Glühbehandlung bei einer entsprechend dem Phasendiagramm geeignet zu wählenden Temperatur einen deutlich höhere Magnetfelddurchgriff aufweisen als Targets gleicher Zusammensetzung, die direkt aus dem Gußbarren oder aus einer knapp unter der Solidustemperatur gewalzten Platte hergestellt sind.

Im Gegensatz hierzu führt eine Glühbehandlung bei Targets, die auf Grund ihrer Zusammensetzung keine Ausscheidungen an intermetallischen Phasen aufweisen, zu keiner Verbesserung des Magnetfelddurchgriffs. Wenn solche Targets jedoch einer der in der Literatur beschriebenen Kaltumformungen unterworfen werden, ergibt sich die erwartete Verbesserung im Magnetfelddurchgriff. Eine anschließende Glühbehandlung bei Temperaturen im Bereich 700°C - 1100°C, entsprechend der vorliegenden Erfindung, führt hier sogar zu einer teilweisen oder vollständigen Zerstörung dieser Verbesserung des Magnetfelddurchgriffs. Um so erstaunlicher ist daher die beobachtete Verbesserung des Magnetfelddurchgriffs für Kobalt-Basislegierungen, die sich von diesen Legierungen nur insofern unterscheiden, als sie geringfügig höhere Anteile der Elemente Ta, B, Mo, W, Hf, V, Nb enthalten, so daß sich jetzt intermetallische Ausscheidungsphasen bilden.

Sorgfältige Gefüge- und Phasenuntersuchungen an entsprechend der vorliegenden Erfindung behandelten Kobalt-Basislegierungen haben gezeigt, daß sich durch die Glühbehandlung Ausscheidungen bilden, die die Korngrenzen oder Zwillingskorngrenzen oder Gleitbänder der Kobalt-Mischkristalle dekorieren. Diese Ausscheidungen enthalten deutliche Anteile der Elemente, die auch die intermetallischen Phasen bilden (s. Bild 1). Außerdem zeigen Phasenuntersuchungen mittels Röntgendiffraktometrie und Elektronen-Mikrosonde, daß sich durch die Glühbehandlung die Zusammensetzung der intermetallischen Phasen ändert bzw. neue intermetallische Phasen gebildet werden. Dies läßt eine fest-fest Umwandlung vermuten, wie sie z.B. auch für des System Co-Ta angegeben wird (Binary Alloy Phase Diagrams, Second Edition, T.M. Massalski (ed.) , ASM International, 1990).

Targets, die ein Gefüge entsprechend der vorliegenden Erfindung aufweisen, zeigen einen deutlich höheren Magnetfelddurchgriff als unbehandelte Targets gleicher Zusammensetzung und Geometrie. Sie sind teilweise sogar Targets überlegen, die wegen des Fehlens der intermetallischen Phasen mittels der in der Literatur beschriebenen Kaltverformungen hergestellt werden müssen.

Tabelle 1 faßt die Versuchsergebnisse zusammen, die an Beispielen entsprechend der vorliegenden Erfindung und an Vergleichsbeispiele gewonnen wurden. Alle Targets wurden über schmelzen der entsprechenden Legierungskomponenten unter Vakuum oder Schutzgas und anschließendem abgießen in eine Kokille hergestellt.

Zur Charakterisierung der magnetischen Targeteigenschaften wurde die zur Targetoberfläche parallele Magnetfeldkomponente gemessen, während das Target auf einem Magnetsatz für eine PK150-Kathode (φ 150 mm) lag. Die Feldstärke Hₓ wird dabei ca. 1 mm oberhalb des Targets registriert. Ohne Target, d.h. direkt auf der Kathodenwanne gemessen, beträgt der Maximalwert H_{x,max} = 95 kA/m.

**Tabelle 1:**

| | | | | | | | |
|---|---|---|---|---|---|---|---|
| Herstellparameter, magnetische Eigenschaften und Gefügecharakterisierung von Targets entsprechend der vorliegenden Erfindung sowie von Targets, die nach Vergleichsverfahren gefertigt wurden. Targetgeometrie zur Bestimmung von H_{x,max}: φ 150 x 6 mm. | | | | | | | |

| Zusammensetzung (at%) | | | Walztemp. (°C) | Glühtemp. (°C) | Glühdauer (h) | Hₓ max (kA/m) | Gefüge |
|---|---|---|---|---|---|---|---|
| A | CoCr(10,5)Ta(4) | | 1150 | 850 | 86 | 50 | wie Bild 1 |
| A | Cocr(10,5)Ta(4) | | - | 880 | 8 | 44 | wie Bild 1 |
| A | CoCr(10,5)Ta(4) | | 1150 | 750 | 360 | 39 | wie Bild 1 |
| B | CoCr(10,5)Ta(4) | 1) 2) | 1200 700 | - | - | 29 | wie Bild 2, Risse |
| A | CoCr(10)Ta(6) | | 1200 | 875 | 22 | 48 | wie Bild 1 |
| B | CoCr(10)Ta(6) | 1) 2) | 1250 700 | - | - | 36 | wie Bild 2, starke Risse |
| C | CoCr(12)Ta(2) | 1) 2) | 1150 350 | - - | - - | 44 | wie Bild 3 |
| C | CoCr(12)Ta(2) | | 1100 | 900 | 16 | 27 | wie Bild 3 |
| A | CoCr(9)Pt(9)Ta(2) | | 1150 | 840 | 8 | 46 | wie Bild 1 |
| B | CoCr(9)Pt(9)Ta(2) | 1) 2) | 100 750 | - | - | 25 | wie Bild 2, starke Risse |
| C | CoCr(11)Pt(10)Ta(1) | | 1150 | 820 | 12 | 28 | wie Bild 3 |
| A | CoCr(10)Ta(5) | | 1100 | 800 | 20 | 41 | wie Bild 1 |
| D | CoCr(10)Ta(5) | | 1200 | 1000 | 8 | 26 | wie Bild 2 |
| C | CoNi(18)Cr(8) | 1) 2) | 1100 300 | - | - | 42 | wie Bild 3 |
| A) Targets entsprechend der vorliegenden Erfindung, | | | | | | | |
| B), C), D) Vergleichsbeispiele | | | | | | | |

### Erläuterungen zu den Beispielen:

### Fall A):

Vor der Glühbehandlung liegt eine Matrix aus primären Mischkristallen vor, in die eutektische Bereiche aus Co-Mischkristallen und intermetallischen Phasen eingelagert sein können. Nach der Glühbehandlung sind die Korngrenzen, Unterkorngrenzen oder Zwillingskorngrenzen oder Gleitbänder mit Elementen dekoriert, die auch die intermetallischen Phasen bilden. Die Glühung erfolgt unterhalb der fest-fest Umwandlung. Es treten Röntgenreflexe einer neuen intermetallischen Phase auf. Sofern schon vor der Glühung intermetallische Phasen beobachtet wurden, ändert sich deren Stöchiometrie und Gitterstruktur.

### Fall B):

Der Ausgangszustand entspricht Fall A. Statt der Glühbehandlung wird jetzt jedoch eine Kaltverformung durchgeführt. Es tritt keine Dekoration der Korngrenzen, Unterkorngrenzen oder Zwillingskorngrenzen oder Gleitbänder auf. Das Material ist jedoch so spröde, daß infolge der Kaltverformung makroskopische Risse entstehen, die das Material unbrauchbar machen bzw. eine wirtschaftliche Fertigung extrem erschweren.

### Fall C):

Es liegen keine intermetallischen Phasen vor, entweder weil kein Element enthalten ist, das mit den anderen Komponenten intermetallische Phasen bildet, oder weil die Konzentration der intermetallischen Phasen bildenden Elemente so gering ist, daß die Löslichkeitsgrenze in keinem Fall überschritte wurde. Hier ist die in der Literatur beschriebene Kaltverformung sehr erfolgreich, während eine Glühbehandlung entsprechend der vorliegenden Erfindung keine Verbesserung gegenüber dem unbehandelten Material bringt. Weder die Walz- noch die Glühbehandlung führt zur Bildung intermetallischer Phasen.

### Fall D):

Der Ausgangszustand entspricht Fall A. Da die Glühungen oberhalb der fest-fest Umwandlungstemperatur erfolgt, tritt keine nennenswerte Veränderung im Gefüge und der Struktur der intermetallischen Phasen auf. Unter Umständen geht ein gewisser Teil der intermetallischen Phasen in Lösung.

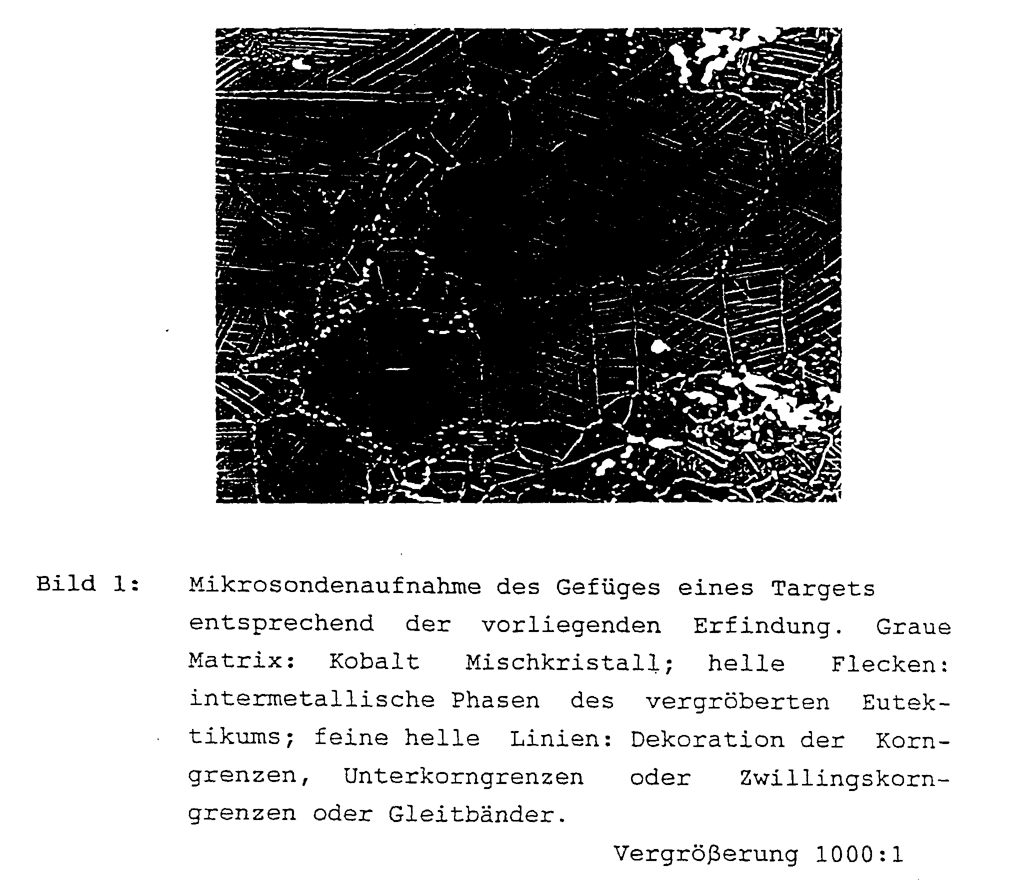

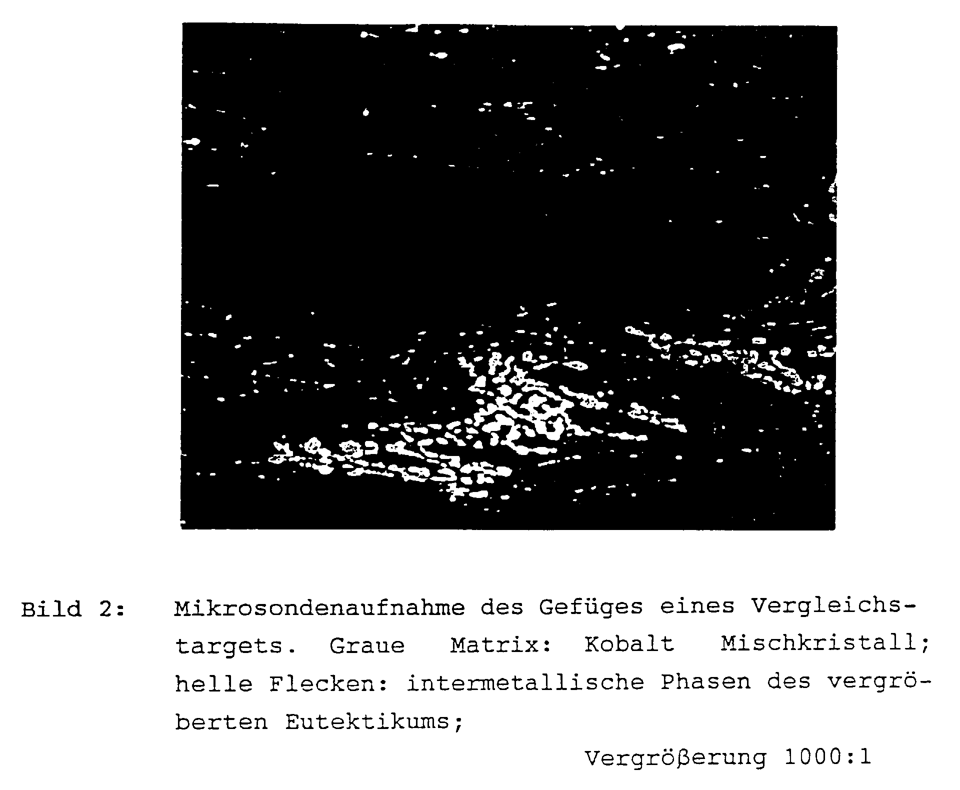

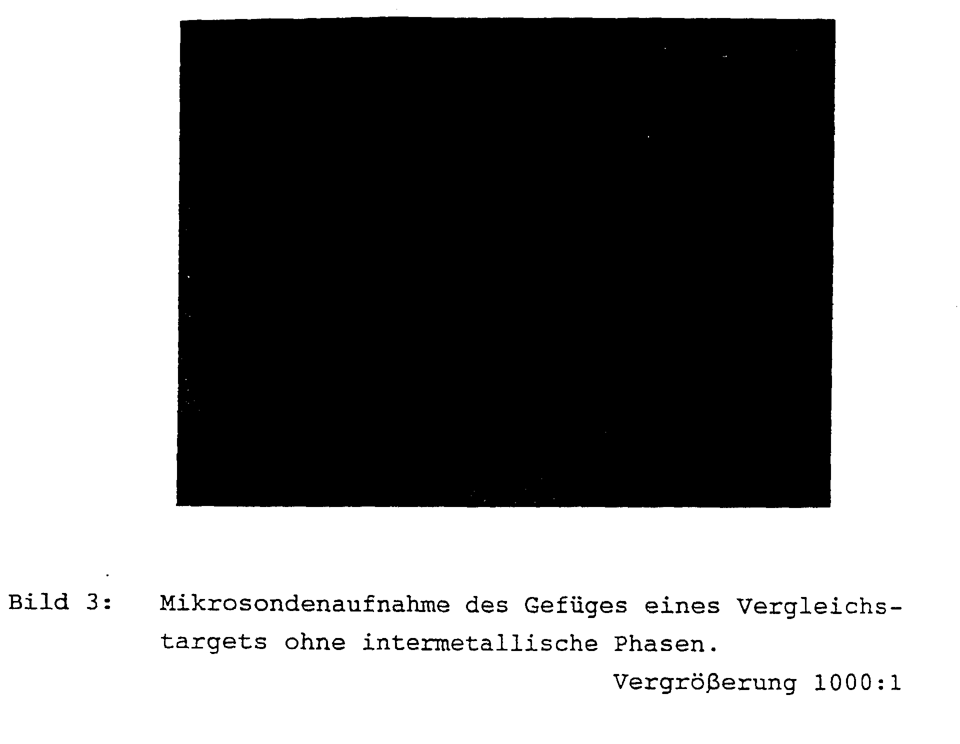

## Patentansprüche

1. Target für Magnetron-Kathodenzerstäubungsanlagen aus einer Kobalt-Basislegierung Co_{1-x-y} MₓR_{y}, wobei M für mindestens eines der Elemente Cr, Pt, Ni, Pd oder ähnliche Elemente der Übergangsmetalle steht und 0 < x < 0,3 ist, R für mindestens eines der Elemente Ta, Mo, W, B, Hf, Nb, V oder ähnliche zur Bildung intermetallischer Phasen neigende Metalle steht und 0,015 < y < 0,20 ist, bestehend aus einem Gefüge aus überwiegend hexagonalen Kobalt-Mischkristallen und mit R gebildeten intermetallischen Phasen, wobei das Targetmaterial mindestens eines der beiden folgenden Merkmale aufweist:
a) Die Korngrenzen, Unterkorngrenzen oder Zwillingskorngrenzen oder Gleitbänder des die Matrix bildenden Kobalt-Mischkristalls sind dekoriert mit den die intermetallischen Phasen bildenden Elementen.
b) Von dem Target hergestellte Röntgenbeugungsdiagramme weisen Reflexe einer intermetallischen Phase auf, die im Gußzustand im wesentlichen abwesend ist und sich erst bei einer Glühung im Temperaturbereich unterhalb der Solidustemperatur der Legierung durch eine Festkörperreaktion bildet.

2. Target nach Anspruch 1, **dadurch gekennzeichnet**, daß die Zusammensetzung Co_{1-x-y} CrₓTa_{y} ist mit 0 < x < 0,3 ; 0,025 < y < 0,15.

3. Target nach Anspruch 1, **dadurch gekennzeichnet**, daß die Zusammensetzung Co_{1-x-y-z} Ptₓ Cr_{y} Ta_{z} ist mit 0 < x < 0,2 ; 0 < y < 0,25 ; 0,015 < z < 0,15.

4. Verfahren zur Herstellung von Targets nach einem der Ansprüche 1 bis 3 **dadurch gekennzeichnet,** daß das Target 1 bis 100 Stunden bei Temperaturen von höchstens 300°C unterhalb der Temperatur für die fest-fest Umwandlungsreaktion geglüht wird.

## Claims

1. Target for magnetron cathodic sputtering apparatus made from a cobalt based alloy Co_{1-x-y}MₓR_{y}, wherein M denotes at least one of the elements Cr, Pt, Ni, Pd or similar transitional metal elements and 0 < x < 0.3 applies, R denotes at least one of the elements Ta, Mo, W, B, Hf, Nb, V or similar metals having a tendency to form intermetallic phases and 0.015 < y < 0.20 applies, consisting of a structure of predominantly hexagonal cobalt mixed crystals and intermetallic phases formed with R, wherein the target material exhibits at least one of the following two features:
a) the grain boundaries, subgrain boundaries or twin grain boundaries or slip bands of the cobalt mixed crystal constituting the matrix are decorated with the elements constituting the intermetallic phases.
b) X-ray diffractograms produced from the target exhibit reflections of an intermetallic phase which is substantially absent in the cast state and is only formed by a solid-state reaction on annealing within a temperature range below the solidus temperature of the alloy.

2. Target according to claim 1, **characterised in that** the composition is Co_{1-x-y}CrₓTa_{y} with 0 < x < 0.3; 0.025 < y < 0.15.

3. Target according to claim 1, **characterised in that** the composition is Co_{1-x-y-z}PtₓCr_{y}Ta_{z} with 0 < x < 0.2; 0 < y < 0.25; 0.015 < z < 0.15.

4. Process for the production of targets according to one of claims 1 to 3, **characterised in that** the target is annealed for 1 to 100 hours at temperatures of at most 300°C below the temperature for the solid/solid transformation reaction.

## Revendications

1. Cible pour appareils de pulvérisation de cathode-magnétrons, constituée d'un alliage à base de cobalt Co_{1-x-y}MₓR_{y}, où M signifie au moins l'un des éléments Cr, Pt, Ni, Pd ou éléments analogues des métaux de transition et x vaut 0 < x < 0,3, R signifie au moins l'un des éléments Ta, Mo, Tu, B, Hf, Nb, V ou métaux analogues ayant tendance à former des phases intermétalliques et y vaut 0,015 < y < 0,20, présentant une structure constituée de cristaux mixtes de cobalt, principalemcnt hexagonaux, et de phases intermétalliques formées avec R, le matériau de la cible présentant au moins l'une des deux caractéristiques suivantes:
a) les limites de grains, les limites des grains divisés, ou les limites des macles, ou des bandes de glissement du cristal mixte de cobalt formant la matrice sont décorées avec les éléments formant les phases intermétalliques.
b) des diagrammcs de diffraction aux rayons X obtenus par la cible présentent des reflets d'une phase intermétallique qui cst sensiblement absente à l'état coulé et qui ne se formc, par une réaction cntre solides, que lors d'un recuit sur la plage de températurc inférieure à la température du solidus de l'alliage.

2. Ciblc selon la revendication 1, caractérisée par le fait quc la composition est Co_{1-x-y} CrₓTa_{y}, avec 0 < x < 0,3; 0,025 < y < 0,15.

3. Cible selon la revendication 1, caractérisée par le fait quc la composition est Co_{1-x-y-z} Ptₓ Cr_{y} Ta_{z}, avec 0 < x < 0,2; 0 < y < 0,25; 0,015 < z < 0,15.

4. Procédé de fabrication de cibles selon l'une des revendications 1 à 3, caractérisé par le fait que l'on recuit la cible pendant 1 à 100 heures à des températures d'au maximum 300°C inférieures à la température de la réaction de conversion solide-solide.
